# EUROPEAN PATENT APPLICATION

(11) **EP 2 587 523 A1**
(43) Date of publication of application: **01.05.2013**
(21) Application number: 12188677.4
(22) Date of filing: 16.10.2012
(51) Int. Cl.: H01L 21/02, H01L 21/20

(54) **Semiconductor device including group iii- v compound semiconductor layer, and method of manufacturing the semiconductor device**

(30) Priority: 31.10.2011 KR 20110112496
(71) Applicant: Samsung Electronics Co., Ltd, Gyeonggi-do 443-742 (KR)
(72) Inventor: Lee, Sang-moon, 449-712 Gyeonggi-do (KR); Shin, Jai-kwang, 449-712 Gyeonggi-do (KR); Cho, Young-jin, 449-712 Gyeonggi-do (KR)
(74) Representative: Greene, Simon Kenneth

(57) **Abstract**

A semiconductor device may include a silicon (Si) substrate including a hole, a hard mask around the hole on the Si substrate, a first material layer filling the hole and on a portion of the hard mask, an upper material layer on the first material layer, and a device layer on the upper material layer. The first material layer may be a Group III-V material layer. The Group III-V material layer may be a Group III-V compound semiconductor layer. The upper material layer may be a portion of the first material layer. The upper material layer may include one of a same material as the first material layer and a different material from the first material layer.

## Description

### BACKGROUND

### Field

Example embodiments relate to semiconductor devices and/or methods of manufacturing the semiconductor devices, and more particularly, semiconductor devices including a Group III-V compound semiconductor layer, and/or methods of manufacturing the semiconductor devices.

### Description of the Related Art

As semiconductor devices are highly integrated, the sizes of and the distances between elements of a semiconductor device are reduced. For example, in a silicon (Si)-based transistor, the sizes of and the distances between source, drain, and gate electrodes are reduced. Because the size of the gate electrode is reduced, the length of a channel is also reduced, and thus, characteristics of the transistor deteriorate due to the short channel effect.

In order to cope with the restriction in size of the gate electrode, research is being conducted on a technology of replacing a channel material with a Group III-V material. Also, research is being conducted on a technology of integrating a Si device and an optical device including a Group III-V material into one device, and a technology of manufacturing a solar cell including a high-efficiency Group III-V material on a Si substrate.

However, due to a large difference in crystal constant and thermal conductivity between a Group III-V material and Si, a relatively large number of defects are formed on an interface between the two materials. As such, the use of a Group III-V material in a Si-based device may be limited.

### SUMMARY

Example embodiments provide semiconductor devices including a Group III-V compound semiconductor layer having reduced growth defects. Example embodiments also provide methods of manufacturing the semiconductor devices.

Additional aspects will be set forth in part in the description which follows and, in part, will be apparent from the description, or may be learned by practice of example embodiments.

According to example embodiments, a semiconductor device may include a silicon (Si) substrate including a hole, a hard mask around the hole on the Si substrate, a first material layer filling the hole and on a portion of the hard mask, the first material layer being a Group III-V material layer, an upper material layer on the first material layer, and a device layer on the upper material layer.

The Group III-V material layer may be a Group III-V compound semiconductor layer. The upper material layer may be a portion of the first material layer. The upper material layer may include one of a same material as the first material layer and a different material from the first material layer.

A buffer layer may be between the first material layer and the upper material layer. A first barrier layer may be between the first material layer and the upper material layer, and a second barrier layer may be on the upper material layer. The device layer may include one of a fin field effect transistor (FinFET), a solar cell, a light-emitting diode (LED), and a laser diode (LD). The buffer layer may include one of a same material as the first material layer and a different material from the first material layer.

The first and second barrier layers may include a material having a bandgap greater than a bandgap of a material of the upper material layer. The first and second barrier layers may include one of a same material as the first material layer and a different material from the first material layer. The first material layer filling the hole may include an empty space. The device layer may include one of a fin field effect transistor (FinFET), a solar cell, a light-emitting diode (LED), and a laser diode (LD).

According to example embodiments, a method of manufacturing a semiconductor device may include forming a hard mask on an upper surface of a silicon (Si) substrate to expose a portion of the upper surface, etching the exposed portion of the substrate to form a hole, growing a first material layer on the hard mask to fill the hole, the first material layer being a Group III-V material layer, growing an upper material layer on the first material layer, and forming a device layer on the upper material layer.

The growing a first material layer may include growing a Group III-V compound semiconductor layer. The growing an upper material layer may include growing one of a same material as the first material layer and a different material from the first material layer. The growing an upper material layer may include growing the upper material layer as a portion of the first material layer, and the growing a first material layer and the growing an upper material layer may occur in sequence.

The forming a device layer may include forming one of a fin field effect transistor (FinFET), a solar cell, a light-emitting diode (LED), and a laser diode (LD). The method may further include flattening an upper surface of the first material layer, growing a buffer layer on the flattened upper surface of the first material layer, and growing the upper material layer on the buffer layer. The growing a buffer layer may include growing one of a same material as the first material layer and a different material from the first material layer.

A first barrier layer may be grown between the first material layer and the upper material layer using a material having a bandgap greater than a bandgap of a material for forming the upper material layer. A second barrier layer may be grown on the upper material layer using a material having a bandgap greater than a bandgap of a material for forming the upper material layer.

The growing a first barrier layer and a second barrier layer may include growing one of a same material as the first material layer and a different material from the first material layer. The growing a first material layer and the growing an upper material layer may include growing one of a binary, ternary, and quaternary Group III-V compound semiconductor.

According to example embodiments, a hole having a predetermined or given depth is formed in a restricted region of a Si substrate, and a Group III-V material is grown from side surfaces of the hole and on the Si substrate. As such, a defect area on an interface between Si and the Group III-V material may be restricted to inside the hole. Accordingly, the density of the defects of the Group III-V material formed on the Si substrate may be reduced. If a growth condition of the Group III-V material is adjusted to form an empty space, e.g., a void, in the Group III-V material grown in the hole, the density of the defects of the Group III-V material formed on the Si substrate may be further reduced.

Because the Group III-V material (a compound semiconductor) having a lower density of defects is used in a semiconductor device, characteristics of the semiconductor device may be improved.

### BRIEF DESCRIPTION OF THE DRAWINGS

These and/or other aspects will become apparent and more readily appreciated from the following description of example embodiments, taken in conjunction with the accompanying drawings in which:
FIGS. 1 through 5 are cross-sectional views for describing a method of manufacturing a semiconductor device, according to example embodiments;
FIG. 6 is a cross-sectional view cut along a line 6-6' illustrated in FIG. 5;
FIG. 7 is a left side view of FIG. 6;
FIG. 8 is a cross-sectional view of a semiconductor device according to example embodiments;
FIG. 9 is a cross-sectional view illustrating a case in a method of manufacturing a semiconductor device according to example embodiments, in which an empty space is formed in a first material layer filled in a hole of a substrate;
FIG. 10 is a cross-sectional view illustrating a case in a method of manufacturing a semiconductor device according to example embodiments, in which a buffer layer further is grown between the first material layer and a channel layer (or an active layer); and
FIG. 11 is a cross-sectional view illustrating a case in a method of manufacturing a semiconductor device according to example embodiments, in which first and second barrier layers are further grown on and under the channel layer (or the active layer).

### DETAILED DESCRIPTION

Reference will now be made in detail to example embodiments, examples of which are illustrated in the accompanying drawings, wherein like reference numerals refer to like elements throughout. In this regard, example embodiments may have different forms and should not be construed as being limited to the descriptions set forth herein. Accordingly, example embodiments are merely described below, by referring to the figures, to explain aspects of the present description.

It will be understood that, although the terms "first", "second", etc. may be used herein to describe various elements, components, regions, layers and/or sections, these elements, components, regions, layers and/or sections are not to be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises", "comprising", "includes" and/or "including," if used herein, specify the presence of stated features, integers, steps, operations, elements and/or components, but do not preclude the presence or addition of one or more other features, integers, steps, operations, elements, components and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments are not to be construed as limited to the particular shapes of regions illustrated herein but are to include deviations in shapes that result, for example, from manufacturing. For example, an implanted region illustrated as a rectangle may have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, is to be interpreted as having a meaning that is consistent with their meaning in the context of the relevant art and will not be interpreted in an idealized or overly formal sense unless expressly so defined herein.

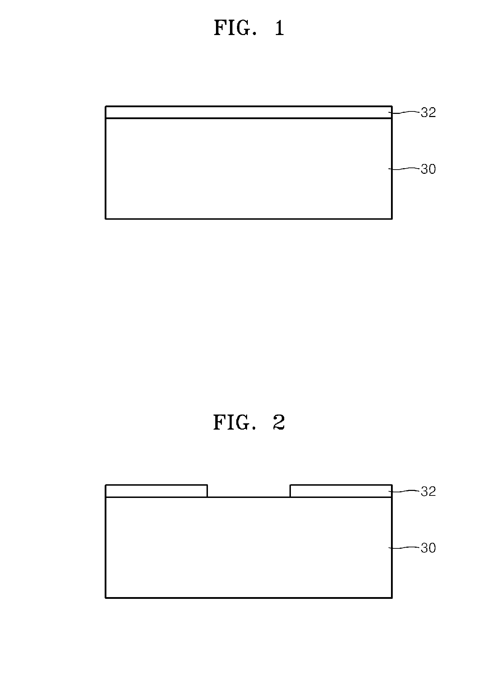

FIGS. 1 through 5 are cross-sectional views for describing a method of manufacturing a semiconductor device, according to example embodiments. Referring to FIG. 1, a hard mask 32 may be formed on a substrate 30. The substrate 30 may be a silicon (Si) substrate. The hard mask 32 may be, for example, a Si oxide mask. The Si oxide may be SiO₂.

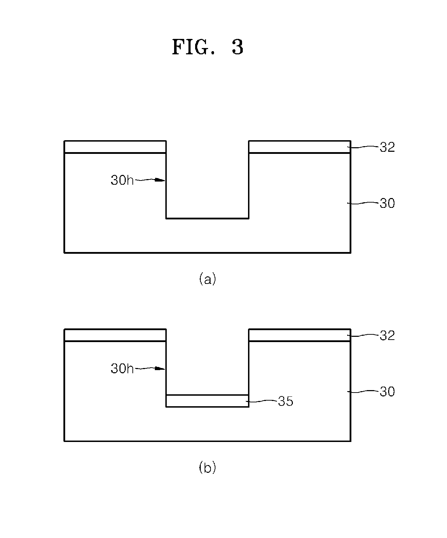

Referring to FIG. 2, a portion of an upper surface of the substrate 30 may be exposed by removing a portion of the hard mask 32. Then, as illustrated in FIG. 3(a), a hole 30h having a predetermined or given depth is formed in the substrate 30 by selectively etching the exposed portion of the upper surface of the substrate 30. The etching may be anisotropic etching.

After the hole 30h is formed, as illustrated in FIG. 3(b), the bottom of the hole 30h is covered with an insulating layer 35 to perform subsequent processes. In example embodiments, the insulating layer 35 may be a Si oxide layer.

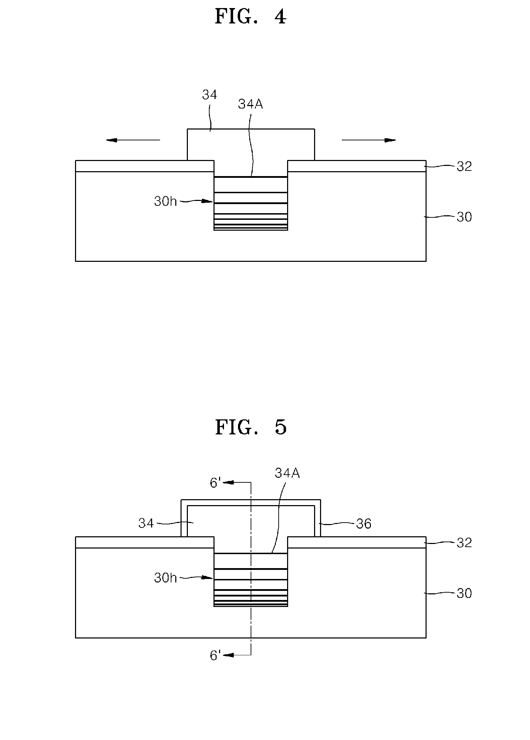

Referring to FIG. 4, a first material layer 34 may be formed on the hard mask 32 to fill the hole 30h. The first material layer 34 may be formed by using an epitaxy method. The first material layer 34 may be formed under the following growth condition.

For example, the first material layer 34 may be grown by using a metal organic chemical vapor deposition (MOCVD) method. In example embodiments, the first material layer 34 may be grown in a reactor at a temperature of about 400 to about 500 °C and under a pressure of about 100 mbar. For example, a gallium arsenide (GaAs) layer may be grown by using a gallium source, e.g., trimethylgallium (TMGa), and arsine (AsH₃) or tertiary-butyl alcohol (TBA). In example embodiments, the first material layer 34 may be grown to a thickness of about 30 nm, and a growth speed may be maintained at about 0.05 to about 0.1 um/hr. After that, the growth temperature may be increased to about 550 to about 700 °C and the growth speed may be increased to about 0.3 um/hr to grow the first material layer 34 faster.

In the above growth condition, the first material layer 34 may be grown faster in a horizontal direction than in a vertical direction. Accordingly, the first material layer 34 may be grown perpendicularly on side surfaces of the hole 30h to fill the hole 30h, and then expands on the hard mask 32. Defects 34A may be formed in a direction perpendicular to the side surfaces of the hole 30h while the first material layer 34 is grown. The density of the defects 34A increases toward the bottom of the hole 30h and decreases away from the bottom of the hole 30h. As such, the defects 34A may be mostly formed in the hole 30h and may be hardly formed in the first material layer 34 outside the hole 30h. In order to form a fin field effect transistor (FinFET), the first material layer 34 may be formed only on a partial region of the hard mask 32 around the hole 30h. For this, after the first material layer 34 is formed on the hard mask 32, the first material layer 34 may be patterned in a predetermined or given shape.

In order to form another type of semiconductor device or optical device, the first material layer 34 may be formed to cover the whole upper surface of the hard mask 32. The first material layer 34 may function as a buffer layer. The first material layer 34 may be, for example, a Group III-V material layer. The Group III-V material layer may include, for example, a compound semiconductor layer. The Group III-V material layer may be formed of a compound including at least one Group III element and at least one Group V element. The at least one Group III element may be at least one of, for example, indium (In), gallium (Ga), and aluminum (AI). The at least one Group V element may be at least one of, for example, arsenic (As), phosphorus (P), and antimony (Sb). As such, the first material layer 34 may be a binary, ternary, or quaternary Group III-V compound layer. If the first material layer 34 is a binary compound layer, the first material layer 34 may be formed of, for example, GaAs, GaP, InP, InAs, GaSb, InSb, AIP, AlAs, or AlSb.

Referring to FIG. 5, a channel layer 36 may be formed as an upper material layer on the first material layer 34 formed on the partial region of the hard mask 32. The channel layer 36 may be formed by using an epitaxy method. The channel layer 36 may be formed to cover upper and side surfaces of the first material layer 34. The channel layer 36 may be formed using the same material as the first material layer 34.

In example embodiments, the channel layer 36 may be a surface layer of the first material layer 34, and a process of forming the channel layer 36 may be included in a process of forming the first material layer 34. That is, if the channel layer 36 is formed using the same material as the first material layer 34, because the surface layer of the first material layer 34 may be used as the channel layer 36, an additional process for forming the channel layer 36 may not be required.

The channel layer 36 may be formed using a different material from the first material layer 34. In example embodiments, the channel layer 36 may be formed using one of the above-mentioned materials for forming the first material layer 34 other than a material used to form the first material layer 34.

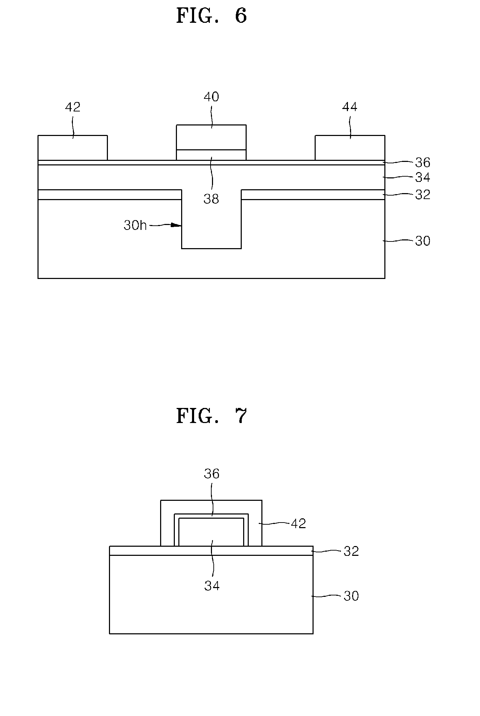

FIG. 6 is a cross-sectional view cut along a line 6-6' illustrated in FIG. 5. Referring to FIG. 6, a gate electrode 40, a source electrode 42, and a drain electrode 44 may be formed on the channel layer 36 with intervals therebetween. The source and drain electrodes 42 and 44 may be simultaneously formed. The gate electrode 40 may be formed before or after the source and drain electrodes 42 and 44 are formed. A gate insulating layer 38 may be further formed between the gate electrode 40 and the channel layer 36. As such, a FinFET in which the channel layer 36 formed of a Group III-V material is formed on the Si-based substrate 30 may be formed. A result of FIG. 6 is formed as a semiconductor device according to example embodiments.

FIG. 7 is a left side view of FIG. 6. Referring to FIG. 7, the upper and side surfaces of the first material layer 34 may be covered with the channel layer 36 that is covered with the source electrode 42. Like the source electrode 42, the drain and gate electrodes 44 and 40 also cover upper and side surfaces of the channel layer 36.

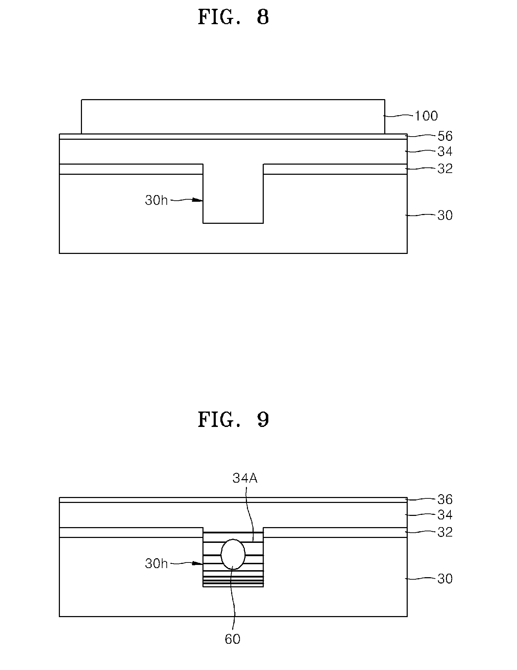

FIG. 8 is a cross-sectional view of a semiconductor device according to example embodiments. Referring to FIG. 8, an active layer 56 may be formed as an upper material layer on the first material layer 34. The active layer 56 may be formed using the same material and the same method as the channel layer 36 illustrated in FIG. 5.

A device layer 100 may be formed on the active layer 56. The device layer 100 may include a solar cell, a light-emitting diode (LED), a laser diode (LD), or an optoelectronic integrated circuit (OEIC) in which LEDs and LDs are integrated. The solar cells, the LEDs, the LDs, and the OEIC may have currently well-known structures, and thus, detailed descriptions thereof will not be provided here.

As illustrated in FIG. 9, in the semiconductor device illustrated in FIG. 6 or 8, when the first material layer 34 is grown, an empty space (or a void) 60 may be formed in the first material layer 34 filled in the hole 30h. The first material layer 34 including the empty space 60 may have the following growth condition.

An MOCVD method is used. In example embodiments, an MOCVD reactor may be maintained at a temperature of about 400 to about 500 °C and under a pressure of about 100 mbar. As an example of the first material layer 34, a GaAs layer may be grown to a thickness of about 60 nm by using a gallium source, e.g., TMGa, and AsH₃ or TBA. In example embodiments, a growth speed may be maintained at about 0.05 to about 0.2 um/hr and then may be increased when the first material layer 34 becomes thicker than about 60 nm. After that, the growth temperature may be increased to about 550 to about 700 °C and the growth speed may be maintained at about 0.3 um/hr.

The empty space 60 may reduce stress caused by differences in lattice constant or thermal expansion coefficient between the substrate 30 and the first material layer 34, and may prevent or reduce the defects 34A from being formed, by growing the first material layer 34 on side surfaces of the hole 30h.

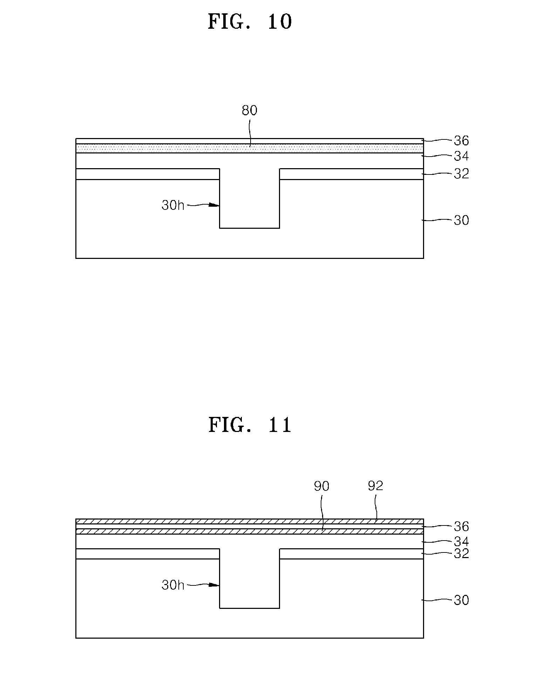

Alternatively, referring to FIG. 10, in the semiconductor device illustrated in FIG. 6 or 8, the upper surface of the first material layer 34 may be flattened to reduce the thickness of the first material layer 34, and a second material layer 80 and the channel layer 36 may be sequentially formed on the flattened first material layer 34. The second material layer 80 may be formed by using the same method and the same material as the first material layer 34. The channel layer 36 may be formed by using the same method as and by using the same material as or a different material from the second material layer 80. If the channel layer 36 is formed by using a different material from the second material layer 80, the channel layer 36 may be formed by using one of the materials for forming the second material layer 80 other than a material used to form the second material layer 80.

Also, referring to FIG. 11, in the semiconductor device illustrated in FIG. 6 or 8, first and second barrier layers 90 and 92 may be respectively formed on and under the channel layer 36. The first and second barrier layers 90 and 92 may be formed using a material having a bandgap greater than the bandgap of a material for forming the channel layer 36. As such, when carriers move in the channel layer 36, the carriers may be prevented or reduced from being scattered on interfaces. The first and second barrier layers 90 and 92 may be formed by using an epitaxy method used to form the first material layer 34. The first and second barrier layers 90 and 92 may be formed of a Group III-V material, e.g., a Group III-V compound semiconductor. In example embodiments, the material used to form the first and second barrier layers 90 and 92 may be selected from the group of materials for forming the first material layer 34.

It should be understood that example embodiments described herein should be considered in a descriptive sense only and not for purposes of limitation. Descriptions of features or aspects within each example embodiment should typically be considered as available for other similar features or aspects in other example embodiments.

## Claims

1. A semiconductor device comprising:
a silicon (Si) substrate including a hole;
a hard mask around the hole on the Si substrate;
a first material layer filling the hole and on a portion of the hard mask, the first material layer being a Group III-V material layer;
an upper material layer on the first material layer; and
a device layer on the upper material layer.

2. The semiconductor device of claim 1, wherein the Group III-V material layer is a Group III-V compound semiconductor layer, wherein the upper material layer is a portion of the first material layer and, wherein the first material layer filling the hole includes an empty space.

3. The semiconductor device of claim 1 or 2, wherein the upper material layer includes one of a same material as the first material layer and a different material from the first material layer and, wherein the device layer includes one of a fin field effect transistor (FinFET), a solar cell, a light-emitting diode (LED), and a laser diode (LD).

4. The semiconductor device of any of claims 1 to 3, further comprising:
a buffer layer between the first material layer and the upper material layer.

5. The semiconductor device of claim 4, wherein the buffer layer includes one of a same material as the first material layer and a different material from the first material layer and, wherein the device layer includes one of a fin field effect transistor (FinFET), a solar cell, a light-emitting diode (LED), and a laser diode (LD).

6. The semiconductor device of any of claims 1 to 5, further comprising:
a first barrier layer between the first material layer and the upper material layer; and
a second barrier layer on the upper material layer.

7. The semiconductor device of claim 6, wherein the first and second barrier layers include a material having a bandgap greater than a bandgap of a material of the upper material layer.

8. A method of manufacturing a semiconductor device, the method comprising:
forming a hard mask on an upper surface of a silicon (Si) substrate to expose a portion of the upper surface;
etching the exposed portion of the substrate to form a hole;
growing a first material layer on the hard mask to fill the hole, the first material layer being a Group III-V material layer;
growing an upper material layer on the first material layer; and
forming a device layer on the upper material layer.

9. The method of claim 8, wherein the growing a first material layer includes growing a Group III-V compound semiconductor layer and, wherein the growing an upper material layer includes growing one of a same material as the first material layer and a different material from the first material layer.

10. The method of claim 8 or 9, wherein the growing an upper material layer includes growing the upper material layer as a portion of the first material layer and, wherein the growing a first material layer and the growing an upper material layer occurs in sequence and, wherein the forming a device layer includes forming one of a fin field effect transistor (FinFET), a solar cell, a light-emitting diode (LED), and a laser diode (LD).

11. The method of claim 8, 9, or 10 further comprising:
flattening an upper surface of the first material layer;
growing a buffer layer on the flattened upper surface of the first material layer; and
growing the upper material layer on the buffer layer.

12. The method of claim 11, wherein the growing a buffer layer includes growing one of a same material as the first material layer and a different material from the first material layer.

13. The method of any of claims 8 to 12, further comprising:
growing a first barrier layer between the first material layer and the upper material layer using a material having a bandgap greater than a bandgap of a material for forming the upper material layer; and
growing a second barrier layer on the upper material layer using a material having a bandgap greater than a bandgap of a material for forming the upper material layer.

14. The method of claim 13, wherein the growing a first barrier layer includes growing one of a same material as the first material layer and a different material from the first material layer and, wherein the growing a second barrier layer includes one of a same material as the first material layer and a different material from the first material layer.

15. The method of any of claims 8 to 14, wherein the growing a first material layer and the growing an upper material layer includes growing one of a binary, ternary, and quaternary Group III-V compound semiconductor.
